# EUROPÄISCHE PATENTANMELDUNG

(11) **EP 1 259 038 A2**
(43) Veröffentlichungstag der Anmeldung: **20.11.2002**
(21) Anmeldenummer: 02010850.2
(22) Anmeldetag: 15.05.2002
(51) Int. Cl.: H04L 25/02

(54) **Regelung und Fehlerkorrektur für Impulsausgabe**

(30) Priorität: 16.05.2001 DE 10123742
(71) Anmelder: SIEMENS AKTIENGESELLSCHAFT, 80333 München (DE)
(72) Erfinder: Müller, Thomas, 76872 Minfeld (DE)

(57) **Zusammenfassung**

Verfahren zur Regelung und Fehlerkorrektur für die Impulsausgabe einer ausgangsseitig mit einer Last verbundenen Impulsausgabebaugruppe, wobei der über den Ausgang der Impulsausgabebaugruppe (8) ausgegebene Impuls oder die Impulsfolge über die Last (7) auf den Eingang (3) der Impulsausgabebaugruppe (8) zurückgeführt wird und anschließend die Impulsdauer oder die Pausendauer zwischen zwei aufeinander folgenden Impulsen dort detektiert wird, danach dieser detektierte Istwert der Impulsdauer oder der Pausendauer zwischen zwei aufeinander folgenden Pulsen mit einem zugehörigen Sollwert verglichen wird und im Falle einer Sollwertabweichung korrigiert wird, sowie eine Anordnung zur Durchführung dieses Verfahrens.

## Beschreibung

Die Erfindung betrifft ein Verfahren zur Regelung und Fehlerkorrektur für die Impulsausgabe einer ausgangsseitig mit einer Last verbundenen Impulsausgabebaugruppe sowie eine Anordnung zur Durchführung dieses Verfahrens.

Derartige Impulsausgabebaugruppen kommen beispielsweise in der Mess- und Regelungstechnik zum Einsatz. Unvorteilhafterweise hat der Anschluss von Lasten an eine Impulsausgabebaugruppe Auswirkungen auf die ausgegebene Impulsform. So ist bei hochohmigen Lasten die Breite des ausgegebenen Impulses in der Regel größer als bei niederohmigen Lasten. Dies ist insbesondere bei geringen Impulsbreiten unerwünscht.

Aufgabe der vorliegenden Erfindung ist es daher, ein Verfahren zur Regelung und Fehlerkorrektur für die Impulsausgabe einer Impulsausgabebaugruppe zu schaffen sowie eine Anordnung zur Durchführung dieses Verfahrens.

Die erfindungsgemäße Lösung dieser Aufgabe ist in den Ansprüchen 1 und 7 angegeben. Die Unteransprüche haben vorteilhafte Weiterbildungen der Erfindung zum Inhalt.

Die Aufgabe der vorliegenden Erfindung wird mit einem Verfahren der eingangs genannten Art gelöst, das sich dadurch auszeichnet, dass der über den Ausgang der Impulsausgabebaugruppe 8 ausgegebene Impuls oder die ausgegebene Impulsfolge über die Last 7 auf den Eingang 3 der Impulsausgabebaugruppe 8 zurückgeführt wird und anschließend die Impulsdauer oder die Pausendauer zwischen zwei aufeinander folgenden Pulsen dort detektiert wird, danach dieser detektierte Istwert der Impulsdauer oder der Pausendauer zwischen zwei aufeinander folgenden Pulsen mit einem zugehörigen Sollwert verglichen und im Falle einer Sollwertabweichung korrigiert wird.

Diese Lösung bietet den Vorteil, dass ungewollte Änderungen in der Impulsdauer oder der Pausendauer zwischen zwei aufeinander folgenden Impulsen automatisch korrigiert werden und die Impulsausgabebaugruppe nicht wie bisher an die entsprechende Last durch hohen Inbetriebsetzungsaufwand angeglichen werden muss.

Eine weitere die Erfindung verbessernde Maßnahme sieht vor, dass die Detektion des Impulses oder der Impulsfolge über eine Abtastung mit der Frequenz fₑ erfolgt und der Impuls oder die Impulsfolge aus den detektierten Werten rekonstruiert wird. Vorteil dieser Ausführungsform ist es, dass die Genauigkeit der Detektion mit steigender Abtastfrequenz erhöht werden kann.

In anderen möglichen Ausführungsformen des erfindungsgemäßen Verfahrens erfolgt eine Rekonstruktion der Impulsdauer derart, dass die Anzahl nᵢ der Abtastwerte zwischen dem Ende einer ersten Pause und dem Beginn der darauf folgenden Pause durch die Abtastfrequenz fₑ dividiert wird. Eine Rekonstruktion der Pausendauer zwischen zwei aufeinander folgenden Impulsen hingegen erfolgt derart, dass die Anzahl nₚ der Abtastwerte zwischen dem Ende eines ersten Impulses und dem Beginn des darauf folgenden Impulses durch die Abtastfrequenz fₑ dividiert wird.

Nach einer weiteren möglichen Weiterbildung des erfindungsgemäßen Verfahrens wird vorgeschlagen, dass der zugehörige Sollwert für die Impulsdauer oder die Pausendauer in einem elektronischen Speicher hinterlegt ist. Dies bietet den Vorteil, dass der Sollwert nicht extern zugeführt werden muss, sondern in der Impulsausgabebaugruppe intern gespeichert werden kann. So kann als elektronischer Speicher beispielsweise ein RAM-Baustein verwendet werden, der in die Impulsausgabebaugruppe integriert ist.

In einer anderen bevorzugten Ausführungsform erfolgt die Detektion des ausgegebenen Impulses oder der ausgegebenen Impulsfolge über eine Abtastung am Ausgang 1 mit der Frequenz fₐ. Danach wird der ausgegebene Impuls oder die ausgegebene Impulsfolge aus den detektierten Werten rekonstruiert und der zugehörige Sollwert für die Impulsdauer oder die Pausendauer zwischen zwei aufeinander folgenden Impulsen in dem elektronischen Speicher 2 hinterlegt.

In einer weiteren bevorzugten Ausführungsform des Verfahrens erfolgt die Regelung und Fehlerkorrektur für die Impulsausgabe der Impulsausgabebaugruppe derart, dass der Istwert der Impulsdauer oder der Pausendauer mit dem zugehörigen Sollwert der Impulsdauer oder der Pausendauer verglichen wird und die Länge des neu ausgegebenen Impulses oder der neu ausgegebenen Pause zwischen zwei aufeinander folgenden Impulsen aus dem zugehörigen Sollwert plus der Differenz zwischen zugehörigem Sollwert und Istwert berechnet wird.

Eine bevorzugte erste Ausführungsform der erfindungsgemäßen Schaltungsanordnung zur Regelung und Fehlerkorrektur für die Impulsausgabe einer Impulsausgabebaugruppe weist einen Ausgang 1, über den die Ausgabe der von der Impulsausgabebaugruppe erzeugten Impulse erfolgt, und einen Eingang 3 auf und zeichnet sich dadurch aus, dass ein Sollwert der Impulsdauer oder der Pausendauer für den ausgegebenen Impuls oder die ausgegebene Impulsfolge vorhanden ist, die Rückführung des auf Eingang 3 zurückgeführten Impulses oder der Impulsfolge über die an Ausgang 1 angeschlossene Last 7 erfolgt, die Schaltungsanordnung ein Auswerteelement 4 zur Berechnung der Impuls- oder Pausendauer aufweist, die Schaltungsanordnung des Weiteren ein Korrekturelement 5 aufweist, das eine Fehlerkorrektur der ausgegebenen Impulsdauer oder der ausgegebenen Pausendauer durchführt, falls die ausgegebene Impulsdauer oder die ausgegebene Pausendauer vom entsprechenden Sollwert abweicht.

Vorteil dieser Schaltungsanordnung ist, dass durch sie die Impulslänge automatisch durch Auswertung der an der Last gemessenen Impulse erfolgen kann. Eine zeit- und kostenintensive Justage der Impulsausgabebaugruppe entsprechend einer daran angeschlossenen Last ist somit nicht mehr erforderlich.

Eine weitere bevorzugte Ausführungsform der erfindungsgemäßen Schaltungsanordnung weist einen Timer 6 auf, mit dem der über den Ausgang 1 ausgegebene Impuls oder die Impulsfolge mit der Frequenz fₑ abgetastet wird. Vorteilhafterweise kann diese Abtastfrequenz des Timers 6 variiert werden, so dass bei hoher Abtastfrequenz die Genauigkeit der Detektion groß ist bzw. bei schnelleren Impulsfolgen die Frequenz fₑ nachgeführt werden kann.

In anderen die Erfindung verbessernden Ausführungsformen beinhaltet die Schaltungsanordnung zur Speicherung der Sollwerte für die Impuls- oder Pausendauern einen elektronischen Speicher. Dieser elektronische Speicher ist bevorzugt nach Art eines RAM oder dergleichen ausgebildet und direkt in die Schaltungsanordnung integriert.

Weiterhin wird in einer anderen bevorzugten Ausführungsform zur Detektion des Sollwertes der Impulsdauer oder der Pausendauer zwischen zwei aufeinander folgenden Impulsen am Ausgang 1 ein Timer 6 verwendet, der Abtastsignale mit der Frequenz fₑ aussendet. Danach wird der entsprechende Sollwert für Impulsdauer oder Pausendauer dem elektronischen Speicher 2 übergeben.

In einer anderen weiteren bevorzugten Ausführungsform der erfindungsgemäßen Schaltungsanordnung erfolgt die Rückführung des auf Eingang 3 zurückgeführten Impulses oder der Impulsfolge über die an Ausgang 1 angeschlossene Last 7 mittels einer elektrischen Leitung 9.

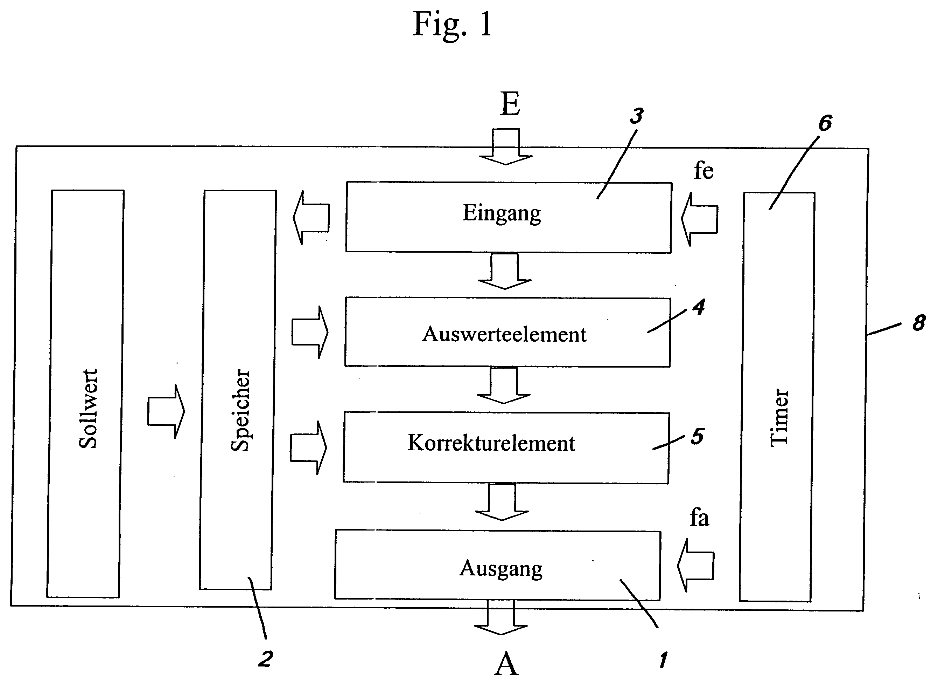

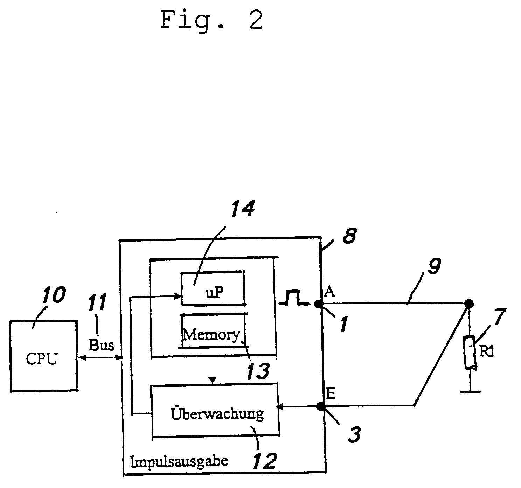

Im Folgenden wird die Erfindung anhand eines bevorzugten Ausführungsbeispiels unter Bezugnahme auf Figur 1 und 2 näher erläutert. Es zeigt:
- Figur 1: eine Prinzipdarstellung der erfindungsgemäßen Fehlerkorrektur;
- Figur 2: eine schaltungstechnische Anordnung in Form eines Blockschaltbildes.

Die Prinzipdarstellung der erfindungsgemäßen Fehlerkorrektur nach Figur 1 zeigt eine Impulsausgabebaugruppe 8 mit einem Ausgang 1, über den Impulse oder Impulsfolgen ausgegeben werden, und einem Eingang 3 zur Aufnahme des über eine Last 7 zurückgeführten Impulses oder der zurückgeführten Impulsfolge.

An diesem Eingang 3 wird die Impulsdauer oder die Pausendauer zwischen zwei aufeinander folgenden Impulsen detektiert. Danach wird dieser detektierte Istwert der Impulsdauer oder der Pausendauer zwischen zwei aufeinander folgenden Pulsen in Auswerteelement 4 mit einem zugehörigen Sollwert verglichen und im Falle einer Sollwertabweichung in Korrekturelement 5 korrigiert.

Ein möglicher Algorithmus zur Fehlerkorrektur des Istwertes lautet: Neuer Ausgabewert für Impulsdauer oder Pausendauer = Sollwert für Impulsdauer oder Pausendauer plus der Differenz zwischen zugehörigem Sollwert und Istwert.

Zur Detektion der Impulsdauer oder der Pausendauer zwischen zwei aufeinander folgenden, über eine Last 7 zum Eingang 3 zurückgeführten Impulsen wird ein Timer 6 verwendet, der Abtastsignale mit der Frequenz fₑ aussendet. Zur Erhöhung der Detektionsgenauigkeit kann die Frequenz, mit der der Timer 6 die Impulsdauer oder die Pausendauer zwischen zwei aufeinander folgenden Impulsen abtastet, vergrößert werden. Bei Ausgabe hochfrequenter Signale kann die Frequenz fₑ erhöht werden.

Der Sollwert für Impulsdauer oder Pausendauer ist in Speicher 2 abgelegt. Bei diesem Speicher kann es sich erfindungsgemäß um einen RAM oder dergleichen handeln, der in die Impulsäusgabebaugruppe integriert ist.

Zur Detektion des Sollwertes der Impulsdauer oder der Pausendauer zwischen zwei aufeinander folgenden Impulsen am Ausgang 1 wird ein Timer 6 verwendet, der Abtastsignale mit der Frequenz fₑ aussendet. Danach wird der entsprechende Sollwert für Impulsdauer oder Pausendauer dem elektronischen Speicher 2 übergeben.

Figur 2 zeigt eine schaltungstechnische Anordnung in Form eines Blockschaltbildes. Zur Steuerung der Impulsausgabebaugruppe ist eine CPU 10 über einen Bus 11 mit der Impulsausgabebaugruppe 8 verbunden. Der über den Ausgang 1 ausgegebene Impuls oder die ausgegebene Impulsfolge wird über die Last 7 mittels eines elektrischen Leiters 9 an den Eingang 3 zurückgeführt und der Überwachungseinheit 12 übergeben. In der Überwachungseinheit 12 befinden sich der Timer 6 zur Detektion des Impulses oder der Impulsfolge, das Auswerteelement 4 zur Berechnung der Impulsdauer oder der Pausendauer und das Korrekturelement 5 zur automatischen Fehlerkorrektur, falls die ausgegebene Impulsdauer oder die ausgegebene Pausendauer vom entsprechenden, im Speicher 13 abgelegten Sollwert abweicht. Die korrigierten Werte für Impulsdauer oder Pausendauer werden dann einem Mikroprozessor 14 übergeben, der einen neuen korrigierten Impuls oder eine neue korrigierte Impulsfolge erzeugt.

## Patentansprüche

1. Verfahren zur Regelung und Fehlerkorrektur für die Impulsausgabe einer ausgangsseitig mit einer Last (7) verbundenen Impulsausgabebaugruppe (8), **dadurch gekennzeichnet, dass** der über den Ausgang der Impulsausgabebaugruppe (8) ausgegebene Impuls oder die ausgegebene Impulsfolge über die Last (7) auf den Eingang (3) der Impulsausgabebaugruppe (8) zurückgeführt wird und anschließend die Impulsdauer oder die Pausendauer zwischen zwei aufeinander folgenden Impulsen dort detektiert wird, danach dieser detektierte Istwert der Impulsdauer oder der Pausendauer zwischen zwei aufeinander folgenden Pulsen mit einem zugehörigen Sollwert verglichen wird und im Falle einer Sollwertabweichung korrigiert wird.

2. Verfahren nach Anspruch 1, **dadurch gekennzeichnet, dass** die Detektion des Impulses oder der Impulsfolge über eine Abtastung mit der Frequenz fₑ erfolgt und der Impuls oder die Impulsfolge aus den detektierten Werten rekonstruiert wird.

3. Verfahren nach Anspruch 2, **dadurch gekennzeichnet, dass** eine Rekonstruktion der Impulsdauer derart erfolgt, dass die Anzahl nᵢ der Abtastwerte zwischen dem Ende einer ersten Pause und dem Beginn der darauf folgenden Pause durch die Abtastfrequenz fₑ dividiert wird.

4. Verfahren nach einem der Ansprüche 2 oder 3, **dadurch gekennzeichnet, dass** eine Rekonstruktion der Pausendauer zwischen zwei aufeinander folgenden Impulsen derart erfolgt, dass die Anzahl nₚ der Abtastwerte zwischen dem Ende eines ersten Impulses und dem Beginn des darauf folgenden Impulses durch die Abtastfrequenz fₑ dividiert wird.

5. Verfahren nach einem der vorherstehenden Ansprüche, **dadurch gekennzeichnet, dass** der zugehörige Sollwert für die Impulsdauer oder die Pausendauer zwischen zwei aufeinander folgenden Impulsen in einem elektronischen Speicher (2) hinterlegt ist.

6. Verfahren nach einem der vorherstehenden Ansprüche, **dadurch gekennzeichnet, dass** die Detektion des ausgegebenen Impulses oder der ausgegebenen Impulsfolge über eine Abtastung am Ausgang (1) mit der Frequenz fₑ erfolgt, danach der ausgegebene Impuls oder die ausgegebene Impulsfolge aus den detektierten Werten rekonstruiert wird und der zugehörige Sollwert für die Impulsdauer oder die Pausendauer zwischen zwei aufeinander folgenden Impulsen in dem elektronischen Speicher (2) hinterlegt wird.

7. Verfahren nach einem der vorherstehenden Ansprüche, **dadurch gekennzeichnet, dass** die Regelung und Fehlerkorrektur für die Impulsausgabe der Impulsausgabebaugruppe derart erfolgt, dass der Istwert der Impulsdauer oder der Pausendauer mit dem zugehörigen Sollwert der Impulsdauer oder der Pausendauer verglichen wird und die Länge des neu ausgegebenen Impulses oder der neu ausgegebenen Pause zwischen zwei aufeinander folgenden Impulsen aus dem zugehörigen Sollwert plus der Differenz zwischen zugehörigem Sollwert und Istwert berechnet wird.

8. Schaltungsanordnung zur Regelung und Fehlerkorrektur für die Impulsausgabe einer Impulsausgabebaugruppe, mit einem Ausgang (1), über den die Ausgabe der von der Impulsausgabebaugruppe erzeugten Impulse erfolgt, und einem Eingang (3), **dadurch gekennzeichnet, dass** ein Sollwert der Impulsdauer oder der Pausendauer für den ausgegebenen Impuls oder die ausgegebene Impulsfolge vorhanden ist, die Rückführung des auf Eingang (3) zurückgeführten Impulses oder der Impulsfolge über die an Ausgang (1) angeschlossene Last (7) erfolgt, die Schaltungsanordnung ein Auswerteelement (4) zur Berechnung der Impuls- oder Pausendauer aufweist, die Schaltungsanordnung des Weiteren ein Korrekturelement (5) aufweist, das eine Fehlerkorrektur der ausgegebenen Impulsdauer oder der ausgegebenen Pausendauer durchführt, falls die ausgegebene Impulsdauer oder die ausgegebene Pausendauer vom entsprechenden Sollwert abweicht.

9. Schaltungsanordnung nach Anspruch 8, **dadurch gekennzeichnet, dass** die Schaltungsanordnung einen Timer (6) aufweist, mit dem der über den Ausgang (1) ausgegebene und über die an Ausgang (1) angeschlossene Last (7) zurückgeführte Impuls oder die Impulsfolge mit der Frequenz fₑ am Eingang (3) abgetastet wird.

10. Schaltungsanordnung nach Anspruch 8 oder Anspruch 9, **dadurch gekennzeichnet, dass** die Schaltungsanordnung zur Speicherung des Sollwertes für die Impuls- oder die Pausendauer zwischen zwei aufeinander folgenden Impulsen einen elektronischen Speicher aufweist.

11. Schaltungsanordnung nach Anspruch 10, **dadurch gekennzeichnet, dass** die Schaltungsanordnung zur Detektion des Sollwertes der Impulsdauer oder der Pausendauer zwischen zwei aufeinander folgenden Impulsen am Ausgang (1) einen Timer (6) aufweist, der Abtastsignale mit der Frequenz fₑ aussendet.

12. Schaltungsanordnung nach Anspruch 10 oder Anspruch 11, **dadurch gekennzeichnet, dass** die Rückführung des auf Eingang (3) zurückgeführten Impulses oder der Impulsfolge über die an Ausgang (1) angeschlossene Last (7) mittels einer elektrischen Leitung (9) erfolgt.
